# EUROPEAN PATENT APPLICATION

(11) **EP 1 864 991 A1**
(43) Date of publication of application: **12.12.2007**
(21) Application number: 06729009.8
(22) Date of filing: 14.03.2006
(51) Int. Cl.: C07F 9/53, H05B 33/12

(54) **ORGANIC LIGANDS FOR SEMICONDUCTOR NANOCRYSTALS**

(30) Priority: 28.03.2005 JP 2005091314
(71) Applicant: IDEMITSU KOSAN CO., LTD., Tokyo 100-8321 (JP)
(72) Inventor: FUKUDA, Masahiko, Chiba, 2990293 (JP); HACHIYA, Satoshi, Chiba, 2990293 (JP); EIDA, Mitsuru, Chiba, 2990293 (JP); KUMA, Hitoshi, Chiba, 2990293 (JP)
(74) Representative: Gille Hrabal Struck Neidlein Prop Roos
(86) International application number: PCT/JP2006/304944
(87) International publication number: WO 2006/103908

(57) **Abstract**

An organic ligand for a semiconductor nanocrystal including a coordinating functional group, a photopolymerizable functional group, and a functional group capable of imparting solubility in an alkaline solution. The photopolymerizable functional group is preferably an ethylenically unsaturated group, and the functional group capable of imparting solubility in an alkaline solution is preferably a carboxyl group.

## Description

### TECHNICAL FIELD

The invention relates to an organic ligand for a semiconductor nanocrystal, a semiconductor nanocrystal, and a color conversion material composition. More particularly, the invention relates to an organic ligand for a semiconductor nanocrystal and a color conversion material composition which exhibits improved resist properties even when the semiconductor nanocrystal is contained at a high concentration and is capable of being patterned readily by photolithography or the like.

### BACKGROUND

A color conversion film which converts the wavelength of light emitted from a light source using a fluorescent material has been applied in various fields such as the electronic display field.
Dispersing an organic fluorescent dye in a liquid photosensitive resin (resist), forming the dispersion into a film by spin coating or the like, followed by pattering by photolithography is widely used as the method for patterning a color conversion film.

As the example of the color conversion film, Patent Document 1 discloses a color conversion substrate in which a patterned green-emitting color conversion medium and a patterned red-emitting color conversion medium, both of which absorb light emitted by an organic electroluminescent (hereinafter electroluminescent is often abbreviated as "EL") device which has a peak wavelength in a region shorter than 480 nm (emission in a blue or bluish green region) are laterally arranged on a plane surface with a space therebetween.
It is known that, however, since an organic fluorescent dye is readily affected by the environment, the fluorescent wavelength may change or quenching may occur depending on the type of a solvent or a resin used, for example.

In particular, if an organic fluorescent dye is dispersed in a liquid resist, discoloration or quenching of the fluorescent dye may occur due to radical or ion species generated from a photoinitiator or a cross linker (photoreactive polyfunctional monomer) in the resist during the process of light exposure or heat treatment (postbaking) of photolithography.

To solve the problem associated with the use of an organic fluorescent dye, Patent Document 2 discloses a full-color organic EL device utilizing a semiconductor nanocrystal. Specifically, a film obtained by dispersing CdS, CdSe, or CdTe as a semiconductor nanocrystal in a light-transmitting resin is used as a fluorescence conversion film, and the fluorescence conversion medium is connected to an organic EL device emitting blue monochromatic color with a peak wavelength of 450 nm, whereby emission of red light and green light is achieved. The colors obtained by conversion such as red and green are controlled by adjusting the particle size of the semiconductor nanocrystal.

The semiconductor nanocrystal, which is obtained by dividing a semiconductor into ultrafine particles (~10 nm), exhibits confinement effects (quantum size effect) for electrons, and as a result, has unique physical properties (absorption/emission capabilities). The characteristics of the semiconductor nanocrystal include the following:
1. Since being formed of an inorganic material, the semiconductor nanocrystal is stable to heat and light, and highly durable.
2. The semiconductor nanocrystal can improve the efficiency of the device since it is not subjected to concentration quenching and has a high fluorescent quantum yield.
3. The semiconductor nanocrystal can realize a high contrast since it is an ultrafine particle and does not undergo light scattering.

In order to prepare a color conversion film utilizing a semiconductor nanocrystal, it is required that the amount of the nanocrystal contained in the film be several tens volume % or more. This amount of nanocrystal is significantly larger than the amount of an organic fluorescent dye (several %). Therefore, if the semiconductor nanocrystal is mixed with a photopolymerizable compound and an alkaline-soluble resin to form a color conversion material composition (resist material), stable patterning cannot be performed since the ratio of the resist components in the composition is low, and the semiconductor nanocrystal is not soluble in an alkaline solution.
[Patent Document 1] JP-A-H05-258860
[Patent Document 2] U.S.P. No. 6,608,439

The invention has been made in view of the above problem, and an object thereof is to provide a color conversion material composition (resist material) containing a semiconductor nanocrystal, which is capable of being patterned stably.

### SUMMARY OF INVENTION

The inventors made extensive studies, and have found that, by using an organic ligand having both a polymerizable functional group and a functional group soluble in an alkaline solution for surface modification of a semiconductor nanocrystal, patterning can be performed with a high definition and a high sensitivity even with a color conversion material composition containing a relatively large amount of a semiconductor nanocrystal. The invention has been made based on this novel finding.
According to the invention, the following ligand for a semiconductor nanocrystal, a semiconductor nanocrystal, a color conversion material composition, a color conversion film, a color conversion substrate, a color display, and a white color display can be provided.

1. An organic ligand for a semiconductor nanocrystal comprising a coordinating functional group, a photopolymerizable functional group, and a functional group capable of imparting solubility in an alkaline solution.
2. An organic ligand for a semiconductor nanocrystal comprising a coordinating functional group and a photopolymerizable functional group.
3. An organic ligand for a semiconductor nanocrystal comprising a coordinating functional group and a functional group capable of imparting solubility in an alkaline solution.
4. The organic ligand for a semiconductor nanocrystal according to 1 or 2, wherein the photopolymerizable functional group is an ethylenically unsaturated group.
5. The organic ligand for a semiconductor nanocrystal according to one of 1, 3 and 4, wherein the functional group capable of imparting solubility in an alkaline solution is a carboxyl group.
6. A semiconductor nanocrystal obtained by coordinating a semiconductor nanocrystal with the organic ligand for a semiconductor nanocrystal according to one of 1 to 5.
7. A semiconductor nanocrystal comprising a first organic ligand having a photopolymerizable functional group and a second organic ligand having a functional group capable of imparting solubility in an alkaline solution, the first and second organic ligands being coordinated on the surface of the semiconductor nanocrystal.
8. The semiconductor nanocrystal according to 7, wherein the photopolymerizable functional group is an ethylenically unsaturated group and the functional group capable of imparting solubility in an alkaline solution is a carboxyl group.
9. The semiconductor nanocrystal according to one of 6 to 8, wherein a bulk material of the semiconductor nanocrystal has a band gap at 20°C of 1.0 eV to 3.0 eV.
10. The semiconductor nanocrystal according to one of 6 to 9, wherein the semiconductor nanocrystal is a core/shell nanocrystal comprising a core particle formed of a semiconductor and a shell layer formed of a second semiconductor having a band gap larger than the band gap of the semiconductor used in the core particle.
11. A color conversion material composition comprising the semiconductor nanocrystal according to one of 6 to 10.
12. The color conversion material composition according to 11 comprising the semiconductor nanocrystal and a binder resin component.
13. The color conversion material composition according to 11 comprising the semiconductor nanocrystal, a binder resin component and a photopolymerizable component.
14. The color conversion material composition according to one of 11 to 13, wherein the semiconductor nanocrystal is contained in a volume fraction of 30% or less.
15. The color conversion material composition according to one of 12 to 14, wherein the binder resin component has a functional group capable of imparting solubility in an alkaline solution.
16. The color conversion material composition according to 15, wherein the functional group capable of imparting solubility in an alkaline solution is a carboxyl group.
17. The color conversion material composition according to one of 13 to 16, wherein the photopolymerizable component has an ethylenically unsaturated group.
18. A color conversion film obtained by using the color conversion material composition according to one of 11 to 17.
19. The color conversion film according to 18 obtained by patterning by photolithography.
20. The color conversion film according to 18 or 19 which has an aspect ratio (vertical/lateral) of 2/1 to 1/100.
21. A color conversion substrate obtained by forming a color conversion film on a supporting substrate, wherein the color conversion film is the color conversion film according to 18.
22. A color conversion substrate obtained by forming a color conversion film by patterning, wherein the color conversion film is the color conversion film according to 19 or 20.
23. A color conversion substrate obtained by forming on a plane surface at least a red (R) color conversion film and a green (G) color conversion film by patterning, wherein the color conversion film is the color conversion film according to 19 or 20.
24. A color conversion substrate obtained by stacking on a supporting substrate a color filter film and the color conversion film according to one of 18 to 20.
25. A color display comprising a light source emitting visible rays and the color conversion film according to one of 18 to 20.
26. A color display comprising a light source emitting visible rays and the color conversion substrate according to one of 21 to 24.
27. A white color display comprising a light source emitting visible rays and the color conversion film according to one of 18 to 20.
28. A white color display comprising a light source emitting visible rays and the color conversion substrate according to one of 21 to 24.

The color conversion material composition (resist material) containing a semiconductor nanocrystal using the organic ligand of the invention can be developed in an alkaline solution even when the semiconductor nanocrystal is added at such a concentration as will allow the nanocrystal to exhibit the function thereof effectively. The color conversion substrate formed from this composition has such emission characteristics as a narrow half width and a high luminance due to the quantum size effects of the semiconductor nanocrystal, and exhibits excellent performance (high degree of color purity and high efficiency) and high definition.

### BEST MODE FOR CARRYING OUT THE INVENTION

### 1. Organic ligand for semiconductor nanocrystal

The organic ligand for the semiconductor nanocrystal of the invention is a compound comprising a coordinating functional group, a photopolymerizable group and/or a functional group capable of imparting solubility in an alkaline solution.
The color conversion material composition is required to have photopolymerizability so that it can be cured upon irradiation of light such as ultraviolet rays, and solubility so that it can be etched in an alkaline solution.
The reason therefor is as follows. In forming the color conversion material composition into a film to be patterned by photolithography, parts irradiated with light such as ultraviolet rays are caused to cure by polymerization and left as they are without being dissolved in an alkaline solution, and parts which are not irradiated with light are caused to be dissolved in an aqueous alkaline solution and are removed.
If the difference in solubility in an aqueous alkaline solution between the irradiated parts and the non-irradiated parts is large, patterning with a high definition of the color conversion film becomes possible (patternability is improved).

There may be a case where the semiconductor nanocrystal is used after surface modification with an organic ligand containing a long-chain alkyl group, a phosphoric acid group, or the like in order to improve dispersibility in a solvent or compatibility with a resin component. The semiconductor nanocrystal which is surface-modified with a conventional organic ligand impairs the solubility of the color conversion material composition in an alkaline solution. Therefore, it is difficult to form a pattern in the color conversion film with a high definition (poor patternability).
The characteristic feature of the invention resides in improvement of patternability of the color conversion material composition by imparting with the organic ligand solubility in an alkaline solution or photopolymerizability and solubility in an alkaline solution. This enables the amount of the semiconductor material in the color conversion material composition to be increased, realizing patterning of the color conversion film with excellent performance (high degree of color purity, high efficiency) and high definition.

The coordinating functional group is a functional group which is coordinated with and bonded to the semiconductor nanocrystal.
As the coordinating functional group, a functional group containing an element belonging to Group 15 or Group 16 of the periodic table can be given. Specific examples include a functional group containing an element belonging to Group 15 of the periodic table such as a primary amino group (-NH₂), a secondary amino group (-NHR; wherein R is a hydrocarbon group having 6 or less carbon atoms such as methyl, ethyl, propyl, butyl, and phenyl. The same can be applied hereinafter), a tertiary amino group (-NR¹R²; wherein R¹ and R² are independently a hydrocarbon group having 6 or less carbon atoms such as methyl, ethyl, propyl, butyl, and phenyl. The same can be applied hereinafter), a functional group containing a nitrogen-containing multiple bond such as nitrile and isocyanate, a nitrogen-containing functional group such as a nitrogen-containing aromatic ring group including a pyridine ring or triazine ring, a phosphor-containing group including a primary phosphine group (-PH₂), a secondary phosphine group (-PHR), a tertiary phosphine group (-PR¹R²), a primary phosphine oxide group (-PH₂=O), a secondary phosphine oxide group (-PHR=O), a tertiary phosphine oxide group (-PR¹R²=O), a primary phosphine selenide group (-PH₂=Se), a secondary phosphine selenide group (-PHR=Se), and a teriary phosphine selenide group (-PR¹R²=Se) ; and a functional group including an element belonging to Group 16 of the periodic table such as a sulfur-containing functional group such as a mercapto group (also known as a thiol group; -SH), a methylsulfide group (-SCH₃), an ethylsulfide group (-SCH₂CH₃), a phenylsulfide group (-SC₆H₅), a methyldisulfide group (-S-S-CH₃), a phenyldisulfide group (-S-S-C₆H₅), a thioacid group (-COSH); a dithioacid group (-CSSH), a xanthogen acid group, a xanthate group, an isothiocyanate group, a thiocarbamate group, and a thiophene ring, and a selenium-containing functional group such as -SeH, -SeCH₃, and -SeC₆H₅, and a tellurium-containing functional group such as -TeH, -TeCH₃, and -TeC₆H₅.

Of these, a functional group containing an element belonging to Group 15 of the periodic table such as a nitrogen-containing functional group such as a pyridine ring and a phosphor-containing functional group such as a tertiary phosphine group, a tertiary phosphine oxide group, and a tertiary phosphine selenide group, and a functional group containing an element belonging to Group 16 of the periodic table such as a sulfur-containing functional group including a mercapto group and a methylsulfide group are preferable. A sulfur-containing group such as a tertiary phosphine group and a tertiary phosphine oxide group or a sulfur-containing functional group such as a mercapto group are still more preferably employed.

A photopolymerizable functional group imparts a resist material with capability of being cured upon irradiation with light. As the photopolymerizable functional group, an ethylenically unsaturated group can be given. Specific examples thereof include an acryloyl group, a methacryloyl group, a vinyl group, a styrene group, and an allyl group.

A functional group capable of imparting solubility in an alkaline solution serves to impart solubility in a developing solution used for removing a resist film.
As the functional group capable of imparting solubility in an alkaline solution, a carboxyl group, a sulfonic acid group, and a phenol group can be given. Of these, a carboxyl group is preferable.

There is no particular limitation on the structure of the organic ligand for the semiconductor nanocrystal of the invention insofar as it has the above-mentioned coordinating functional group, a photopolymerizable functional group, and a functional group capable of imparting solubility in an alkaline solution. For example, a phosphoric acid compound shown below is preferable.

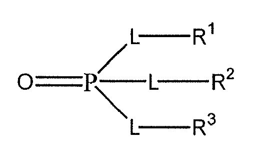

wherein at least one of R¹ to R³ is a photopolymerizable functional group, and at least one of R¹ to R³ is a functional group capable of imparting solubility in an alkaline solution; L is an aliphatic group having 2 to 16 carbon atoms which is bonded to the phosphor atom of the phosphine oxide group (O=P) via a carbon atom (L may contain in its structure a non-aromatic bond containing an arbitrary hetero atom such as an oxygen-containing bond including an ether bond, an ester bond, a carbonate bond, and a ketone bond, or a nitrogen-containing bond such as an amide bond, an urethane bond and an uric acid bond).

### 2. Semiconductor nanocrystal

The semiconductor nanocrystal of the invention can be obtained by coordinating the surface of a known semiconductor nanocrystal with the above-mentioned organic ligand for the semiconductor nanocrystal of the invention or the first organic ligand containing a photopolymerizable functional group and the second organic ligand containing a functional group capable of imparting solubility in an alkaline solution.

The semiconductor nanocrystal is obtained by finely dividing a crystal of a semi conductor material to the order of nanometer. As the nanocrystal of a semiconductor material, a fine particle capable of absorbing visible rays and emitting fluorescence having a wavelength longer than the wavelength of the absorbed light can be used.

To effectively absorb visible rays without causing scattering and to emit fluorescence having a longer wavelength, it is preferred that the fine particle have a particle size of 20 nm or less, more preferably 10 nm or less.
The band gap of a bulk semiconductor is preferably 1.0 eV to 3.0 eV. If the band gap is less than 1.0 eV, the resulting nanocrystal has a fluorescence wavelength which changes to a large extent corresponding to a change in the particle diameter, whereby the production management becomes difficult. If the band gap exceeds 3.0 eV, since the resulting nanocrystal emits only fluorescence having a wavelength shorter than that in the near ultraviolet region, it is difficult to use such a material for a color light-emitting apparatus.

The band gap of a bulk semiconductor was obtained as follows. An optical absorption of a bulk semiconductor specimen at 20°C was measured. The band gap was obtained from a photon energy corresponding to a wavelength where the absorption coefficient increases to a large degree.

As the semiconductor material, a crystal formed of an element belonging to Group 14 of the periodic table, a compound of an element belonging to Group 2 and an element belonging to Group 16, a compound of an element belonging to Group 12 and an element belonging to Group 16, a compound of an element belonging to Group 13 and an element belonging to Group 15 or a chalcopyrite compound can be given.
Specific examples thereof include crystals of Si, Ge, MgS, ZnS, MgSe, ZnSe, AlP, GaP, AlAs, GaAs, CdS, CdSe, InP, InAs, GaSb, AlSb, ZnTe, CdTe, InSb, CuAlS₂, CuAlSe₂, CuAlTe₂, CuGaS₂, CuGaSe₂, CuGaTe₂, CuInS₂, CuInSe₂, CuInTe₂, AgAlS₂, AgAlSe₂, AgAlTe₂, AgGaS₂, AgGaSe₂, AgGaTe₂, AgInS₂, AgInSe₂, AgInTe₂, ZnSiP₂, ZnSiAs₂, ZnGeP₂, ZnGeAs₂, ZnSnP₂, ZnSnAs₂, ZnSnSb₂, CdSiP₂, CdSiAs₂, CdGeP₂, CdGeAs₂, CdSnP₂, CdSnAs₂, and mixed crystals of these elements or compounds.
Of these, A1P, GaP, Si, ZnSe, AlAs, GaAs, CdSe, InP, ZnTe, AlSb, CdTe, CuGaSe₂, CuGaTe₂, CuInS₂, CuInSe₂ and CuInTe₂ are preferable. In particular, ZnSe, GaAs, CdSe, InP, ZnTe, CdTe, CuInS₂ and CuInSe₂ (direct transition semiconductors) are still more preferable from a viewpoint of high luminous efficiency and light absorption efficiency of the excitation light source.

The semiconductor nanocrystal may be produced using a known method such as that disclosed in U.S.P. No. 6,501,091. U.S.P. No. 6,501,091 discloses a production example in which a precursor solution prepared by mixing trioctyl phosphine (TOP) with trioctyl phosphine selenide and dimethylcadmium is added to trioctyl phosphine oxide (TOPO) heated at 350°C.

As another example of the semiconductor nanocrystal used in the invention, a core/shell semiconductor nanocrystal can be given. The core/shell semiconductor nanocrystal has a structure in which the surface of a core particle formed of CdSe (band gap: 1.74 eV) is coated (covered) with a shell formed of a semiconductor material having a large band gap such as ZnS (band gap: 3.8 eV), for example. This ensures that confinement effects for electrons produced in the core particle are easily developed.

The core/shell semiconductor nanocrystal may be produced using a known method such as that disclosed in U.S.P. No. 6,501,091. For example, a CdSe core/ZnS shell structure may be produced by adding a precursor solution prepared by mixing TOP with diethylzinc and trimethylsilyl sulfide to a TOPO solution heated at 140°C in which CdSe core particles are dispersed.

In the above specific examples of the semiconductor nanocrystal, a phenomenon tends to occur in which S, Se, or the like is removed by an active component (e. g. unreacted monomer or water) in a transparent medium to damage the crystal structure of the nanocrystal, whereby the fluorescent properties disappear. In order to prevent this phenomenon, the surface of the semiconductor nanocrystal may be modified with a metal oxide such as silica.

The semiconductor nanocrystal may be used either singly or in combination of two or more kinds.

As the first organic ligand having a photopolymerizable functional group, a compound having the above-mentioned coordinating functional group and a photopolymerizable functional group can be used.
As the second organic ligand having a functional group capable of imparting solubility in an alkaline solution, a compound having the above-mentioned coordinating functional group and a functional group capable of imparting solubility in an alkaline solution can be used.

It is preferred that the first organic ligand and the second organic ligand be present in the semiconductor nanocrystal at a ratio (molar ratio) of about 10:1 to 1:10.

As the method for bonding the above-mentioned various organic ligands to the semiconductor nanocrystal, known methods including a method utilizing a ligand exchange reaction, a method in which an organic ligand is added to a hot-soap reaction liquid phase, and a method in which an organic ligand is added to a Reverse Micelle Method reaction liquid phase can be used.

### 3. Color conversion material composition

The color conversion material composition of the invention can be divided into the following three types:
(a) A composition containing the above-mentioned semiconductor nanocrystal
(b) A composition containing the above-mentioned semiconductor nanocrystal and a binder resin component
(c) A composition containing the above-mentioned semiconductor nanocrystal, a binder resin component and a photopolymerizable component
The color conversion material composition may contain only the semiconductor nanocrystal with which the organic ligand is coordinated. However, the color conversion material composition preferably contains a binder resin component in order to attain improved mechanical stability and high definition. It is more preferred that the color conversion material composition also contain a photopolymerizable component.
Usable binder resin components include a copolymer of (meth) acrylic acid and (meth) acrylic acid alkyl ester (examples of the alkyl group include methyl, ethyl, and butyl), a copolymer of poly(meth)acrylic acid, styrene, and an unsaturated dibasic anhydride such as maleic anhydride, a reaction product of the polymer with an alcohol and a reaction product of the polymer with a polybasic anhydride of cellulose.

As the binder resin component, it is preferable to use a copolymer which can be dissolved in an aqueous alkaline solution, which is disclosed in JP-A-64-55550, JP-A-05-036581, JP-A-2003-064135, or the like. Specific examples include a copolymer of acrylic acid or methacrylic acid, which is a monomer containing a carboxyl group, and a monomer of an acrylic acid ester or a methacrylic acid ester.
As the ester compound of acrylic acid and methacrylic acid, ethylene glycol monomethyl ether (meth)acrylate, diethylene glycol monomethyl ether (meth)acrylate, triethylene glycol monomethyl ether (meth)acrylate, tetraethylene glycol monomethyl ether (meth)acrylate, ethylene glycol monoethyl ether (meth)acrylate, diethylene glycol monoethyl ether (meth)acrylate, triethylene glycol monoethyl ether (meth)acrylate, tetraethylene glycol monoethyl ether (meth) acrylate, or the like can be given. It is preferred that these copolymers have a molecular weight of 5,000 to 200,000.

As the photopolymerizable component, a compound containing an ethylenically unsaturated group can be given. Specific examples include (meth)acrylic acid esters, (meth)acrylamides, allyl compounds, vinyl ether compounds, vinyl esters, and styrene compounds.

Specific examples of the (meth) acrylic acid ester include diethylene glycol di(meth)acrylate, triethylene glycol di(meth)acrylate, tetraethylene glycol di(meth)acrylate, nonaethylene glycol di(meth)acrylate, tetradecaethylene glycol di(meth)acrylate, nonapropylene glycol di(meth)acrylate, dodecapropylene glycol di(meth)acrylate, trimethylol propane tri(meth)acrylate, tri(meth)acrylate of an ethylene oxide adduct of trimethylol propane, pentaerythritol di(meth)acrylate, pentaerythritol tri(meth)acrylate, pentaerythritol tetra(meth)acrylate, dipentaerythritol hexa(meth)acrylate, glycerin di(meth)acrylate, and 1,3-propandiol di(meth)acrylate.

Examples of the (meth) acrylamide include, in addition to methylene-bis-(meth)acrylamide, ethylenediamine, diaminopropane, diaminobutane, pentamethylenediamine, bis(2-aminopropyl)amine, diethylene triamine diamine, phenylenediamine, and poly(meth)acrylamide derived from diaminobenzoic acid, or the like.

As the allyl compound, diallyl esters of phthallic acid, mallonic acid or the like, and diallyl esters of benzenedisulfonic acid, 2,5-dihydroxydisulfonic acid or the like can be given.

As the vinyl ether compound, ethylene glycol divinyl ether, 1,3,5-tri-β-vinyloxyethoxybenzene, or the like can be given.

As the vinyl esters, divinyl succinate, divinyl adipate , or the like can be given.

As the styrene compound, divinylbenzene, p-allylstyrene or the like can be given.

Also, a polyfunctional urethane compound containing at least two ethylenically unsaturated groups which can be obtained by reacting a compound having at least one hydroxy group and at least one ethylenically unsaturated group with a reaction product obtained by reacting a polyol compound having at least two hydroxy groups and a slightly excessive amount of a polyisocyanate compound having at least two isocyanate groups can preferably be employed in the invention.

As the binder resin component, a compound containing a photopolymerizable functional group can preferably be used. For example, a copolymer containing an ethylenically unsaturated group which can be dissolved in an aqueous alkaline solution as disclosed in JP-A-05-339356 can be given. If such a binder resin component is used, a photopolymerizable component is not necessarily added.

In the color conversion material composition of the invention, it is preferred that the volume fraction of the semiconductor nanocrystal be 5 to 30% in order to allow the semiconductor nanocrystal to fully exhibit the performance thereof. If the volume fraction of the semiconductor nanocrystal exceeds 30%, patternabiliy of the composition may deteriorate. Conventionally, when the volume fraction of the semiconductor nanocrystal is 5 to 30%, the amount of the component in the composition which does not have patternability increases. As a result, the composition has poor patternability, and hence, it is difficult to form a pattern with a high definition by photolithography. In the invention, by imparting the organic ligand present on the surface of the semiconductor nanocrystal with solubility in an alkaline solution, or photopolymerizability and solubility in an alkaline solution, the ratio of the resist materials in the color conversion material composition increases. As a result, the amount of the semiconductor nanocrystal in the color conversion composition can be increased, whereby high-performance patterning (high color purity and high efficiency) of a color conversion film can be attained with a high precision.

It is preferred that the photopolymerizable component be contained in an amount of 10 to 200 parts by weight per 100 parts by weight of the binder resin component. It is more preferred that the binder resin component be contained in an amount of 30 to 150 parts by weight. If the amount of the photopolymerizable component is less than 10 parts by weight, the resultant color conversion film may be poor in resistance to solvent. If the amount of the photopolymerizable component exceeds 200 parts by weight, tack properties of a precured film may deteriorate.

The color conversion material composition of the invention may contain a photopolymerization initiator, if necessary.
It is preferred that the photopolymerization initiator contain at least one component having a molecular absorption coefficient of at least about 50 in a range of about 300 to 800 nm, more preferably 330 to 500 nm. Examples of the photopolymerization initiator include aromatic ketones, rofin dimers, benzoin, benzoin ethers, polyhalogens, and combination of two or more of these. Specific examples include the following compounds.

Examples of the aromatic ketones include benzophenone, 4,4'-bis(dimethylamino)benzophenone, 4-methoxy-4'-dimethylaminobenzophenone, 4,4'-dimethoxybenzophenone, 4-dimethylaminobenzophenone, 4-dimethylaminoacetophenone, benzyl, anthraquinone, 2-tert-butyl-anthraquinone, 2-methylanthraquinone, xanthone, thioxanthone, 2-chlorothioxanthone, 2,4-diethylthioxanthone, fluorenone, and acrydone.

As the preferred rofin dimers, those described in JP-B-45-37377, JP-B-48-38403, JP-A-56-35134, and Japanese Patent Application No. 63-200605 can be given. Specific examples include 2-(o-chlorophenyl)-4,5-diphenylimidazole dimer, 2-(O-chlorophenyl)-4,5-di (m-methoxyphenyl)imizaole dimer, 2-(o-fluorophenyl)-4,5-diphenylimidazole dimer, 2-(o-methoxyphenyl)-4,5-diphenylimidazole dimer, and 2-(p-methoxyphenyl)-4,5-diphenylimidazole dimer.

Examples of the benzoin and the benzoin ethers include benzoin methyl ether, benzoin ethyl ether, benzoin isopropyl ether, and benzoin phenyl ether.

Examples of the polyhalogen compound include carbon tetrabromide, phenyltribromomethylphenylsulfone, phenyltrichloromethylketone, and compounds disclosed in JP-A-53-133428, JP-B-57-1819, JP-B-57-6096, and U.S.P. No. 3,615,455. More preferred examples of the polyhalogen compound include 4,4'-bis(dimethylamino)benzophenone, 4,4'-bis(diethylamino)benzophenone, 2,4-diethylthioxantone, a combination of 4,4'-bis(diethylamino)benzophenone and benzophenone, and a combination of 4,4'-bis(diethylamino)benzophenone and phenyltribromomethylphenylsulfone.

The color conversion material composition of the invention may further contain an additive such as a cure initiator, a heat polymerization inhibitor, a plasticizer, a filler, a solvent, a defoaming agent, and a leveling agent, if necessary.
The color conversion material composition of the invention is capable of forming a high-performance color conversion film utilizing the characteristics of the semiconductor nanocrystal only by forming into a film without performing patterning by photolithography. The composition of the invention does not suffer deterioration or agglomeration of the semiconductor nanocrystal by forming the composition into a film.

### 4. Color conversion film

The color conversion film of the invention can be produced by a known method. For example, the color conversion film of the invention can be produced by the following method. The above-mentioned color conversion material composition is dissolved in a solvent to form a solution. The resulting solution is applied onto the surface of the substrate, and precured to dry the solvent (prebaking). After applying a photomask, the resulting film is irradiated with active rays to cause the irradiated parts to be cured. The non-irradiated parts are eluted by development with a weak aqueous alkaline solution, thereby forming a pattern. Postbaking as the post drying is performed to prepare a color conversion film.

As the method for applying the solution of the color conversion material composition onto a substrate, a known method such as dip coating and spray coating can be used. Also, a roll-coater, a land coater, or a spinner coater can be used without restrictions.

Prebaking is performed by heating with an oven, a hot plate or the like. Temperature and time of heating in prebaking can be appropriately selected depending on the type of the solvent used. For example, prebaking is performed at 80°C to 150°C for 1 to 30 minutes. Exposure to light after prebaking is performed using an exposing machine. Only a resist corresponding to a pattern to be formed is sensitized by exposure to light through a photomask. An exposing machine and conditions for exposure or irradiation can be selected appropriately. As the light for irradiation, visible rays, UV rays, X-rays, electron beams or the like can be used. Though the amount of irradiated light is not particularly restricted, it can be selected in a range of from 1 to 3,000 mJ/cm², for example.

Development in an alkaline solution after light exposure is performed in order to remove a resist which is not irradiated. A desired pattern can be formed by this development. As the developer suited to the development in an alkaline solution, an aqueous solution of a carbonate of an alkaline metal or an alkaline earth metal can be used. In particular, it is preferred that development be performed at 10°C to 50°C, preferably 20°C to 40°C using a weak aqueous alkaline solution containing 1 to 3 wt% of a carbonate such as sodium carbonate, potassium carbonate and lithium carbonate. A minute image can be formed precisely using a commercial developing machine, a ultrasonic cleaner, or the like.

After the development, a heat treatment (post baking) is performed at 80°C to 220°C for 10 to 120 minutes. The post baking is performed to improve adhesion between the patterned color conversion film and the substrate. Like the prebaking, the postbaking is performed by heating using an oven, a hot plate or the like. The color conversion film of the invention can be formed by the so-called photolithography, which includes the above-mentioned steps.
If the patterning is not performed, the above-mentioned step of exposure or postbaking may be omitted.

As the thickness of the color conversion film, a thickness which is required to convert the wavelength of incident light into a desired wavelength has to be chosen. Normally, the thickness of the color conversion film is 1 to 100 µm. A thickness of 1 to 20 µm is particularly preferred.
The aspect ratio (vertical/lateral) of the color conversion film is preferably 2/1 to 1/100 in order to obtain a highly precise pattern with a large thickness.

### 5. Color conversion substrate

The color conversion substrate of the invention is a substrate obtained by forming color conversion films using the above-mentioned color conversion material compositions. Further, the color conversion substrate of the invention is obtained by forming on a supporting substrate at least red (R) color conversion film and green (G) color conversion film by patterning to provide pixels. These pixels are the color conversion substrates formed by the color conversion material composition of the invention.
As the supporting substrate, it is preferable to use a flat and smooth substrate having a transmittance of 50% or more to rays within visible ranges of 400 to 700 nm. Specifically, a glass substrate or a polymer plate is used. Examples of the glass substrate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

In the color conversion substrate of the invention, it is possible to adjust color purity by providing a color filter to obtain a desired wavelength. Usable color filters include a perylene-based pigment, a lake pigment, an azo-based pigment, a quinacridone-based pigment, an anthraquinone-based pigment, an anthracene-based pigment, an isoindoline-based pigment, an isoindolinone-based pigment, a phthalocyanine-based pigment, a triphenylmethane-based basic dye, an indanthrone-based dye, an indophenol-based dye, a cyanine-based dye, and a dioxazine-based dye, which may be used singly or in combination of two or more. A solid-state substrate obtained by dissolving or decomposing a dye in a binder resin may also be used.

### 6. Color display

The color display of the invention is obtained by combining the above-mentioned color conversion film or the color conversion substrate with a light source, and can emit a plurality of color light selectively.
As the light source for the color conversion film or the color conversion substrate, an organic EL device, an LED device, a cold-cathode tube, an inorganic EL device, a fluorescent lamp, an incandescent lamp or the like can be given. Of these, an organic EL device and an LED device which generate a small amount of UV rays which deteriorate the binder resin component are particularly preferable.

### 7. White color display

The white color display of the invention, which emits white color light, is obtained by combining the color conversion film or the color conversion substrate as mentioned above with a light source.
White color light can be obtained by mixing light emitted from the light source for the above-mentioned color conversion film or the color conversion substrate with fluorescence from the color conversion film or the color conversion substrate. For example, green and/or red fluorescence can be obtained in parts where the color conversion film is formed, and light from a blue light source transmits through parts where the color conversion film is not formed, thereby obtaining white color light. The white color display of the invention can be used as a white color lamp or a backlight or the like.

### EXAMPLES

The invention will be described in more detail by referring to Examples.

### Synthesis Example 1

### Synthesis of core/shell semiconductor nanocrystal

Specifically, cadmium acetate dihydrate (0.5 g) and tetradecylphosphonic acid (TDPA) (1.6 g) were added to 5 ml of trioctyl phosphine (TOP). The solution was heated to 230°C in a nitrogen atmosphere and stirred for one hour. After cooling the solution to 60°C, 2 ml of a TOP solution containing 0.2 g of selenium was added to the solution to obtain a raw material solution.
Trioctyl phosphine oxide (TOPO) (10 g) was placed in a three-necked flask and dried at 195°C for one hour under vacuum. After adjusting the pressure inside the flask to atmospheric pressure using nitrogen gas, the TOPO was heated to 270°C in a nitrogen atmosphere. 1.5 ml of the above-obtained raw material solution was then added to the TOPO while stirring the system. The core growth reaction was allowed to proceed while appropriately checking the fluorescence spectrum of the reaction solution. When the nanocrystal exhibited a fluorescence peak at 615 nm, the reaction solution was cooled to 60°C to terminate the reaction.
20 ml of butanol was added to the reaction solution to precipitate the semiconductor nanocrystal (core). The semiconductor nanocrystal was separated by centrifugation and dried under reduced pressure, whereby a semiconductor nanocrystal for red emission was obtained.
In the similar synthesis method as mentioned above, when the nanocrystal exhibited a fluorescence peak at 530 nm, the reaction solution was cooled to 60°C to terminate the reaction, whereby a semiconductor nanocrystal for green emission was obtained.

TOPO (5 g) was placed in a three-necked flask and dried at 195°C for one hour under vacuum. After adjusting the pressure inside the flask to atmospheric pressure using nitrogen gas, the TOPO was cooled to 60°C in a nitrogen atmosphere. Then, TOP (0.5 ml) and the above-obtained semiconductor nanocrystal (core) (0.05 g) suspended in 0.5 ml of hexane were added to the TOPO. After stirring the mixture at 100°C for one hour under reduced pressure, the mixture was heated to 160°C. The pressure inside the flask was then adjusted to atmospheric pressure using nitrogen gas to obtain solution A.
A separately-prepared solution B (prepared by dissolving 0.7 ml of a 1N n-hexane solution of diethyl zinc and 0.13 g of bis (trimethylsilyl) sulfide in 3 ml of TOP) was added dropwise to the solution A maintained at 160°C over 30 minutes. The temperature was raised to 90°C, and stirring was continued for further two hours. After cooling the mixture to 60°C, 20 ml of butanol was added to the reaction solution to precipitate the semiconductor nanocrystal (core: CdSe, shell: ZnS). The semiconductor nanocrystal was separated by centrifugation and dried under reduced pressure. The resultant product will be abbreviated as CdSe/ZnS-TOPO.
Transmission electron microscopic observation reveled that the particle size of the semiconductor crystal for red emission was 5.2 nm and the particle size of the semiconductor crystal for green emission was 4.0 nm.

### [Organic ligand]

### Example 1

The MMPO shown below was synthesized by the following method.

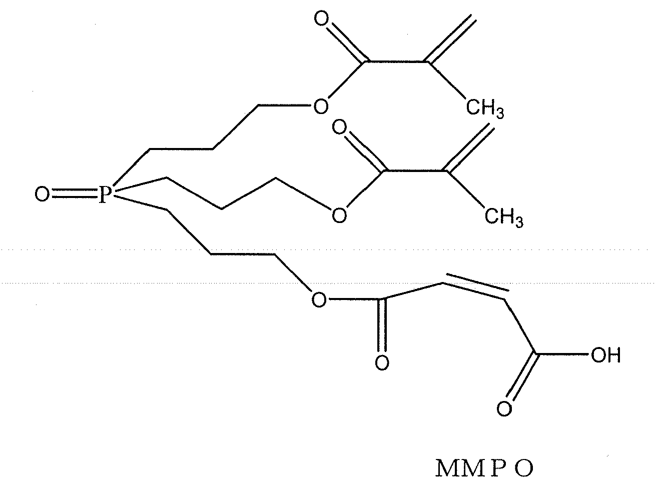

3.96 g of tris(3-hydroxypropyl)phosphine oxide (HPPO) (0.0177 mole) was added to 100 ml of pyridine. While stirring the mixture at room temperature under dry nitrogen atmosphere, 8.44 g (0.0547 mole) of methacrylic anhydride and 40 ml of DMF were added. After stirring at room temperature for about 3.5 hours, the mixture was heated at 60°C for about one hour. The resultant transparent homogeneous solution was allowed to stand at room temperature for about 100 hours. 1.90 g of maleic anhydride (0.0194 mole) was added, and the resultant mixture was allowed to stand at room temperature to convert an unreacted hydroxy group to a maleic acid ester. Volatile components were removed by concentration under a reduced pressure.
NMR was conducted for the resultant product. From the integrated intensity ratio between olefin protons of a methacryloyl group and a maleic acid group and a methyl proton of a methacryloyl group, it was revealed that, of the three hydroxy groups of HPPO, two hydroxy groups were converted to a methacryloyl group and the remaining one hydroxy group was converted to maleic acid.

### Example 2

As the ligand containing an ethylenically unsaturated group (photopolymerizable), MTPO shown below was synthesized by the following method.

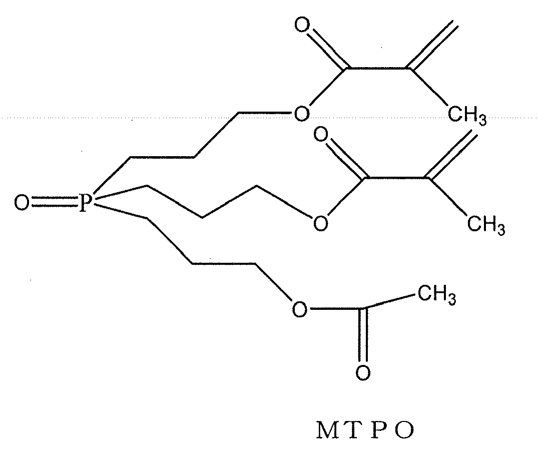

3.96 g of tris(3-hydroxypropyl)phosphine oxide (HPPO) (0.0177 mole) was added to 100 ml of pyridine. While stirring the mixture at room temperature under dry nitrogen atmosphere, 8.44 g (0.0547 mole) of methacrylic anhydride and 40 ml of DMF were added. After stirring at room temperature for about 3.5 hours, the mixture was heated at 60°C for about one hour. The resultant transparent homogeneous solution was allowed to stand at room temperature for about 100 hours. Acetic anhydride (1.98 g; 0. 0194 mole) was added, and the resultant mixture was allowed to stand at room temperature to convert an unreacted hydroxy group to an acetic acid ester. Volatile components were removed by concentration under reduced pressure.
NMR was conducted for the resultant product. From the integrated intensity ratio between olefin protons of a methacryloyl group and maleic acid group and a methyl proton of a methacryloyl group, it was revealed that, of the three hydroxy groups of HPPO, two hydroxy groups were converted to a methacryloyl group and the remaining one hydroxy group was converted to an acetic acid ester.

### Example 3

As the ligand containing a carboxyl group (soluble in an alkaline solution), MAPO shown below was synthesized by the following method.

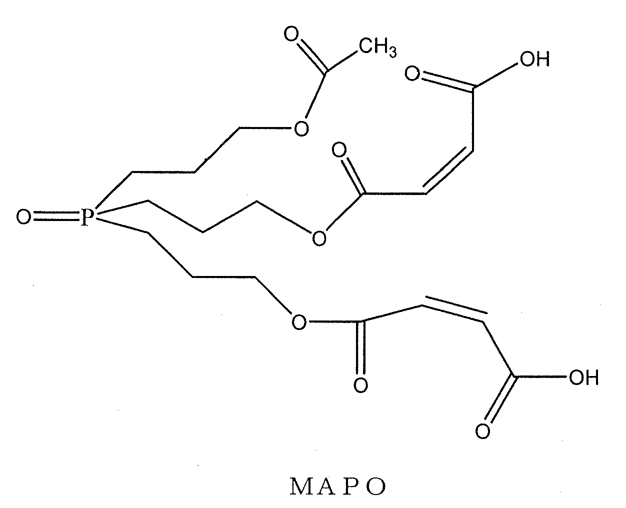

3.96 g of tris(3-hydroxypropyl)phosphine oxide (HPPO) (0.0177 mole) was added to 100 ml of pyridine. While stirring the mixture at room temperature under dry nitrogen atmosphere, 5.36 g (0.0547 mole) of maleic anhydride and 40 ml of DMF were added. After stirring at room temperature for about 3. 5 hours, the mixture was heated at 60°C for about one hour. The resultant transparent homogeneous solution was allowed to stand at room temperature for about 100 hours. Acetic anhydride (1.98 g; 0.0194 mole) was added, and the resultant mixture was allowed to stand at room temperature to convert an unreacted hydroxy group to an acetic acid ester. Volatile components were removed by concentration under reduced pressure.
NMR was conducted for the resultant product. From the integrated intensity ratio between an olefin proton of a maleic acid group and a methyl proton of an acetyl group, it was revealed that, of the three hydroxy groups of HPPO, two hydroxy groups were converted to a maleic acid ester group and the remaining one hydroxy group was converted to an acetic acid ester.

### [Semiconductor nanocrystal]

### Example 4

The CdSe/ZnS-TOPO obtained in Synthesis Example 1 was dissolved in purified toluene. The MMPO obtained in Example 1 was added to the resultant solution and allowed to react sufficiently. Then, the solution was added dropwise to butanol in the same manner as in Synthesis Example 1 to precipitate, followed by centrifugation and decantation. As a result, a semiconductor nanocrystal with the organic ligand MMPO being coordinated (CdSe/ZnS-MMPO) was prepared.

### Example 5

The CdSe/ZnS-TOPO obtained in Synthesis Example 1 was dissolved in purified toluene. The MTPO obtained in Example 2 was added to the resultant solution and allowed to react sufficiently. Then, the solution was added dropwise to butanol in the same manner as in Synthesis Example 1 to precipitate, followed by centrifugation and decantation. As a result, a semiconductor nanocrystal with the organic ligand MTPO being coordinated (CdSe/ZnS-MTPO) was prepared.

### Example 6

The CdSe/ZnS-TOPO obtained in Synthesis Example 1 was dissolved in purified toluene. The MAPO obtained in Example 3 was added to the resultant solution and allowed to react sufficiently. Then, the solution was added dropwise to butanol in the same manner as in Synthesis Example 1 to precipitate, followed by centrifugation and decantation. As a result, a semiconductor nanocrystal with the organic ligand MAPO being coordinated (CdSe/ZnS-MAPO) was prepared.

### [Color conversion material composition/color conversion film]

### Example 7

### (1) Preparation of a color conversion material composition

35 parts by weight of CdSe/ZnS-MMPO obtained in Example 4 and 15 parts by weight of a copolymer of benzyl methacrylate and methacrylic acid (molecular weight: 27,000; copolymerization ratio=molar ratio of a methacrylate component to the total components: 0.72) and 15 parts by weight of dipentaerythrythol hexacrylate (DPHA) were dissolved in 35 parts by weight of propylene glycol monomethyl ether acetate (PGMEA) as the solvent, whereby a color conversion material composition was obtained.

### (2) Fabrication of color filter substrate

On a glass substrate of 100 mm by 100 mm by 1.1 mm thick, V259R (manufactured by Nippon Steel Chemical Co., Ltd) as the material for a red color filter was applied by spin coating, and dried at 120°C for 2 minutes. Ultraviolet rays were applied to the material through a photomask for forming a stripe pattern (line/space=50µm/50µm) . The material was then developed using a 2% aqueous sodium carbonate solution, and baked at 200°C to obtain a red color filter (film thickness: 1.5 µm).

### (3) Production of color conversion film

The color conversion material composition obtained in (1) above was applied to the substrate obtained in (2) above by spin coating, dried at 120°C for 2 minutes. Ultraviolet rays were applied to the material through a photomask for forming a stripe pattern (line/space=50µm/50µm) such that the stripe pattern was aligned with the color filter lines. The material was then developed with a 2% aqueous sodium carbonate solution, and baked at 200°C to obtain a color conversion film. The resultant color conversion film had a thickness of 20 µm and a width of 50 µm (aspect ratio: 2/5)
The cross section of the obtained film was observed by a transmission electron microscope to calculate the volume fraction of the semiconductor nanocrystal contained in the film, and the volume fraction was found to be 29%.

### (4) Fabrication of organic EL device

On a glass substrate with a dimension of 25 mm × 75 mm × 1.1 mm, ITO was applied to have a thickness of 130 nm by sputtering to obtain a transparent supporting substrate. Subsequently, the substrate was subjected to ultrasonic cleaning for 5 minutes in isopropyl alcohol. Then, the substrate was dried by blowing nitrogen, followed by 10-minute cleaning with UV ozone (UV 300, manufactured by Samco International Co., Ltd).
The transparent supporting substrate was transferred to an organic deposition device (manufactured by ULVAC, Inc.) and installed on a substrate holder. Molybdenum heating boats were respectively charged in advance with 4,4',4"-tris[N-(3-methylphenyl)-N-phenylamino]triphenylamin e (MTDATA) as a hole-injecting material and 4,4'-bis[N-(1-naphthyl)-N-phenylamino]biphenyl (NPD), 4,4'-bis(2,2-diphenylvinyl)biphenyl (DPVBi) as an emitting material, and tris (8-quinolinol) aluminum (Alq) as an electron-injecting material. Further, an Al-Li alloy as a cathode (Li concentration: 10 atom%) was secured to a tungsten filament.

After reducing the pressure inside the vacuum container to 5×10⁻⁷ torr, layers were stacked as described below in the order from the hole-injecting layer to the cathode by a single vacuum evacuation without breaking the vacuum.
As the hole-injecting layer, MTDATA was deposited to a thickness of 60 nm at a deposition rate of 0.1 to 0.3 nm/sec and NPD was deposited to a thickness of 20 nm at a deposition rate of 0.1 to 0.3 nm/sec. As the emitting layer, DPVBi was deposited to a thickness of 50 nm at a deposition rate of 0.1 to 0.3 nm/sec. As the electron-injecting layer, Alq was deposited to a thickness of 20 nm at a deposition rate of 0.1 to 0.3 nm/sec. As the cathode, an Al-Li alloy was deposited to a thickness of 150 nm at a deposition rate of 0. 5 to 1. 0 nm/sec. After forming an organic EL device on the substrate, the substrate was transferred to a dry box in which dry nitrogen was circulating such that the substrate was not in contact with atmosphere. In this dry box, a display part was covered with a glass plate as a sealing substrate, and parts surrounding the display part were sealed by photo-curing using a cation-curable adhesive (TB3102: manufactured by ThreeBond Co., Ltd.).
Thus, an organic EL device was fabricated. A voltage of 7V was applied to the device. The measurement was conducted using a spectrophotometer from the side of the transparent supporting substrate, and it was found that blue emission with a luminance of 230 cd/m² and CIE chromaticity coordinates of X=0.16 and Y=0.30 was obtained.

### (5) Evaluation of color conversion film

The color conversion substrate and the transparent supporting substrate of the above-obtained organic EL device were laminated through silicone oil with a refractive index of 1.53 such that the color conversion substrate and the transparent supporting substrate were opposed. A voltage of 7V was applied to the organic EL device. The measurement was conducted using a spectrophotometer, and it was found that good red emission with a luminance of 120 cd/m² and CIE chromaticity coordinates of X=0.650 and Y=0.342 was obtained. The conversion efficiency defined by the ratio of the luminance of the converted light to the light emitted from the light source was as good as 52%.
The composition of the color conversion material compositions and the properties of the color conversion films obtained in Example 7, Examples 8 to 11 and Comparative Example 1 are shown in Table 1.

**[Table 1]**

| | Composition of color conversion material composition | | | | | Properties of color conversion film | | | |
|---|---|---|---|---|---|---|---|---|---|
| | Organic ligand used | Mixing ratio (parts by weight) | | | | Thickness | Line/Space | Aspect ratio | Volume fraction of naocrystal |
| | | Semiconductor nanocrystal (NC) | Binder resin | Cross linker | Solvent | (µm) | (µm/µm) | | |
| Example 7 | MMPO | 35 | 15 | 15 | 35 | 20 | 50/50 | 2/5 | 29 |
| Example 8 | MMPO | 25 | 20 | 20 | 35 | 20 | 20/20 | 1/1 | 20 |
| Example 9 | MTPO, MAPO | 35 | 15 | 15 | 35 | 20 | 50/50 | 2/5 | 28 |
| Example 10 | MTPO, MAPO | 25 | 20 | 20 | 35 | 20 | 20/20 | 1/1 | 22 |
| Example 11 | MMPO | 35 | 15 | 15 | 35 | 1 | 100/100 | 1/100 | 29 |
| Comparative Example 1 | TOPO | 35 | 15 | 15 | 35 | Patterning impossible | | | - |

| | | | | | | | | | |
|---|---|---|---|---|---|---|---|---|---|
| TOPO: Trioctylphosphine oxide | | | | | | | | | |

### Example 8

25 parts by weight of CdSe/ZnS-MMPO obtained in Example 4 and 20 parts by weight of a copolymer of benzyl methacrylate and methacrylic acid (molecular weight: 27,000; copolymerization ratio=molar ratio of a methacrylate component to the total components:0.72) and 20 parts by weight of dipentaerythrythol hexacrylate (DPHA) were dissolved in 35 parts by weight of propylene glycol monomethyl ether acetate (PGMEA) as the solvent, whereby a color conversion material composition was obtained.
Using the color conversion material composition, a color conversion film was prepared in the same manner as in Example 7 using a photomask for forming a striped pattern (line/space= 20µm/20µm). As a result, a film with a striped pattern having a thickness of 20 µm was obtained (aspect ratio=1/1). The cross section of the obtained film was observed by a transmission electron microscope to calculate the volume fraction of the semiconductor nanocrystal contained in the film, and the volume fraction was found to be 20%. The conversion efficiency was 52.3% and the chromaticity coordinates were (0.652, 0.344).

### Comparative Example 1

A color conversion material composition was prepared in the same manner as in Example 7 except that the semiconductor nanocrystal obtained in Synthesis Example 1 was used and the composition was varied to that shown in Table 1. A color conversion film was prepared from the color conversion material composition, but a striped pattern could not be formed.

### Example 9

17 parts by weight of CdSe/ZnS-MTPO obtained in Example 5 and 18 parts of CdSe/ZnS-MAPO obtained in Example 6, and 15 parts by weight of a copolymer of benzyl methacrylate and methacrylic acid (molecular weight: 27,000; copolymerization ratio=molar ratio of a methacrylate component to the total components: 0.72) and 15 parts by weight of dipentaerythrythol hexacrylate (DPHA) were dissolved in 35 parts by weight of propylene glycol monomethyl ether acetate (PGMEA) as the solvent, whereby a color conversion material composition was obtained.
Using the color conversion material composition, a color conversion film was prepared in the same manner as in Example 7 using a photomask for forming a striped pattern (line/space= 50µm/50µm). As a result, a striped pattern with a thickness of 20 µm was obtained (aspect ratio=2/5). The cross section of the obtained film was observed by a transmission electron microscope to calculate the volume fraction of the semiconductor nanocrystal contained in the film, and the volume fraction was found to be 28%. The conversion efficiency was 51.3% and the chromaticity coordinates were (0.650, 0.3447).

### Example 10

The color conversion material composition and the color conversion film were prepared in the same manner as in Example 9, except that the composition of the color conversion material composition and the line/space of the photomask were varied to those shown in Table 1. An excellent pattern was formed, as is apparent from Table 1.

### Example 11

Using the same material composition as in Example 7, a color conversion film with a thickness of 1 µm was prepared using a mask pattern (100µm/100µm). An excellent pattern was obtained.

### Example 12

### Preparation of color conversion substrate

V259BK (manufactured by Nippon Steel Chemical Co., Ltd.) as the material for a black matrix (BM) was applied by spin coating on a supporting substrate (OA2 glass manufactured by Nippon Electric Glass Co., Ltd.) having dimensions of 112 mm × 143 mm × 1.1 mm. Then, ultraviolet rays were applied through a photomask for forming a lattice-shaped pattern. The material was then developed using a 2% sodium carbonate aqueous solution and baked at 200°C to obtain a black matrix pattern (thickness: 1.5 µm).
V259B (manufactured by Nippon Steel Chemical Co., Ltd.) as the material for a blue color filter was applied by spin coating After positioning to the black matrix, ultraviolet rays were applied to the material through a photomask patterned so that 320 rectangular stripe patterns (90-µm line and 240-µm gap) were obtained. The material was then developed using a 2% sodium carbonate aqueous solution and baked at 200°C to obtain a blue color filter pattern (thickness: 1.5 µm). Subsequently, the material for the green color filter (material: V259G) and the material for the red color filter (material: V250R) were shifted vertically relative to the stripe line of the stripe pattern of the blue color filter by a pitch of 110 µm. After exposing to UV rays, the material was developed using a 2% sodium carbonate aqueous solution and baked at 200°C, whereby a green color filter and a red color filter were obtained.
As the material for the red conversion film, a color conversion material composition prepared in the same manner as in Example 7 using the semiconductor nanocrystal for red emission prepared in Synthesis Example 1 was used. Using the same photomask as mentioned above, a red color conversion film was formed on the red color filter in a thickness of 15 µm. As the material for the green conversion film, a color conversion material composition prepared using the semiconductor nanocrystal for green emission prepared in Synthesis Example 1 was used, and a green conversion film was formed on a green color filter.
An acrylic thermosetting resin ("V259PH" manufactured by Nippon Steel Chemical Co., Ltd.) was applied on the substrate by spin coating and then baked at 160°C to form a planarizing film (thickness: 5 µm). Thus, a color conversion substrate in which a red color conversion film, a green color conversion film, and a blue color conversion film were formed by patterning on the plane surface was obtained.

### Example 13

### Color display

A color display was prepared by combining the color conversion substrate obtained in Example 12 and the organic EL device obtained in Example 7.

### INDUSTRIAL APPLICABILITY

The color conversion material composition containing a semiconductor nanocrystal using the organic ligand of the invention can preferably be used in producing a color conversion film of various displays. The color conversion substrate obtained using this composition is suitable for use in a color display since it has improved emission characteristics such as a narrow half width and a high luminance due to the quantum size effects of the semiconductor nanocrystal, and can exhibit excellent performance (high degree of color purity and high efficiency) and high definition. The resultant color display can be used as displays for public and industrial applications, specifically, displays for mobile phones, PDAs, car navigators, monitors and TVs.
A white color display can be used as a white color lamp, backlight, or the like.

## Claims

1. An organic ligand for a semiconductor nanocrystal comprising a coordinating functional group, a photopolymerizable functional group, and a functional group capable of imparting solubility in an alkaline solution.

2. An organic ligand for a semiconductor nanocrystal comprising a coordinating functional group and a photopolymerizable functional group.

3. An organic ligand for a semiconductor nanocrystal comprising a coordinating functional group and a functional group capable of imparting solubility in an alkaline solution.

4. The organic ligand for a semiconductor nanocrystal according to claim 1 or 2, wherein the photopolymerizable functional group is an ethylenically unsaturated group.

5. The organic ligand for a semiconductor nanocrystal according to one of claims 1, 3 and 4, wherein the functional group capable of imparting solubility in an alkaline solution is a carboxyl group.

6. A semiconductor nanocrystal obtained by coordinating a semiconductor nanocrystal with the organic ligand for a semiconductor nanocrystal according to one of claims 1 to 5.

7. A semiconductor nanocrystal comprising a first organic ligand having a photopolymerizable functional group and a second organic ligand having a functional group capable of imparting solubility in an alkaline solution, the first and second organic ligands being coordinated on the surface of the semiconductor nanocrystal.

8. The semiconductor nanocrystal according to claim 7, wherein the photopolymerizable functional group is an ethylenically unsaturated group and the functional group capable of imparting solubility in an alkaline solution is a carboxyl group.

9. The semiconductor nanocrystal according to one of claims 6 to 8, wherein a bulk material of the semiconductor nanocrystal has a band gap at 20°C of 1.0 eV to 3.0 eV.

10. The semiconductor nanocrystal according to one of claims 6 to 9, wherein the semiconductor nanocrystal is a core/shell nanocrystal comprising a core particle formed of a semiconductor and a shell layer formed of a second semiconductor having a band gap larger than the band gap of the semiconductor used in the core particle.

11. A color conversion material composition comprising the semiconductor nanocrystal according to one of claims 6 to 10.

12. The color conversion material composition according to claim 11 comprising the semiconductor nanocrystal and a binder resin component.

13. The color conversion material composition according to claim 11 comprising the semiconductor nanocrystal, a binder resin component and a photopolymerizable component.

14. The color conversion material composition according to one of claims 11 to 13, wherein the semiconductor nanocrystal is contained in a volume fraction of 30% or less.

15. The color conversion material composition according to one of claims 12 to 14, wherein the binder resin component has a functional group capable of imparting solubility in an alkaline solution.

16. The color conversion material composition according to claim 15, wherein the functional group capable of imparting solubility in an alkaline solution is a carboxyl group.

17. The color conversion material composition according to one of claims 13 to 16, wherein the photopolymerizable component has an ethylenically unsaturated group.

18. A color conversion film obtained by using the color conversion material composition according to one of claims 11 to 17.

19. The color conversion film according to claim 18 obtained by patterning by photolithography.

20. The color conversion film according to claim 18 or 19 which has an aspect ratio (vertical/lateral) of 2/1 to 1/100.

21. A color conversion substrate obtained by forming a color conversion film on a supporting substrate, wherein the color conversion film is the color conversion film according to claim 18.

22. A color conversion substrate obtained by forming a color conversion film by patterning, wherein the color conversion film is the color conversion film according to claim 19 or 20.

23. A color conversion substrate obtained by forming on a plane surface at least a red (R) color conversion film and a green (G) color conversion film by patterning, wherein the color conversion film is the color conversion film according to claim 19 or 20.

24. A color conversion substrate obtained by stacking on a supporting substrate a color filter film and the color conversion film according to one of claims 18 to 20.

25. A color display comprising a light source emitting visible rays and the color conversion film according to one of claims 18 to 20.

26. A color display comprising a light source emitting visible rays and the color conversion substrate according to one of claims 21 to 24.

27. A white color display comprising a light source emitting visible rays and the color conversion film according to one of claims 18 to 20.

28. A white color display comprising a light source emitting visible rays and the color conversion substrate according to one of claims 21 to 24.
